# EUROPEAN PATENT SPECIFICATION

(11) **EP 1 419 578 B1**
(45) Date of publication and mention of the grant of the patent: **23.01.2008**
(21) Application number: 02713089.7
(22) Date of filing: 21.03.2002
(51) Int. Cl.: H03K 3/00

(54) **PULSE-WIDTH MODULATION WITH FEEDBACK TO TOGGLE MODULE**
IMPULSBREITENMODULATOR MIT RÜCKKOPPLUNG ZU EINER KIPPSCHALTUNG
MODULATION DE LARGEUR D'IMPULSION A RETOUR VERS MODULE A BASCULE

(30) Priority: 22.03.2001 US 815145
(43) Date of publication of application: 19.05.2004
(73) Proprietor: NXP B.V., 5656 AG Eindhoven (NL)
(72) Inventor: HOUGHTON, William, NL-5656 AA Eindhoven (NL)
(74) Representative: Pennings, Johannes
(86) International application number: PCT/IB2002/000829
(87) International publication number: WO 2002/078184

(56) References cited:
- EP-A- 0 868 028
- US-A- 5 485 487
- US-A- 5 675 297

## Description

### FIELD OF THE INVENTION

The present invention is directed to a digital signal generation and, more particularly, to pulse-width modulation systems and methods.

### BACKGROUND

Pulse-width modulation (PWM) is commonly used in digital signal processing arrangements for a wide variety of applications. In some applications, an input stimulus is used to generate a signal having constant-amplitude pulses, where the width of each pulse is proportional to the values of the input stimulus. The sampling rate of the input signal is sufficiently fast to satisfy the applicable sampling theorem and thereby provide an adequately accurate PWM output signal. The demands for PWM circuits have been so significant that many of today's programmable ICs, including microcontroller (*aka* microprocessor) chips, have built-in PWM circuits with one or more dedicated input/output chip pins.

Whether as part of a higher-functioning (*e.g.,* programmable) IC or using discrete logic circuits, the PWM output signal is typically generated using various modules including a timer/counter ("counter"), a compare-value holding register, and a comparator. EP 868 028, US 5 675 297 and US 5 485 487 give examples of such PWM circuits. When the PWM output signal is used with a microprocessor, the microprocessor is sometimes directly involved with the other modules in producing the PWM output signal. Relative to the cycle times required for processor instructions, however, generating the PWM output signal can take a long time. When one of the microprocessor tasks is to assist in generating the PWM output signal, the software running on the microprocessor is typically interrupted in real time to perform various duties associated with the processing of the counter, the compare-value holding register, and the comparator. Because these interruptions occur frequently and typically occupy relatively significant windows of microprocessor processing time, the chip's microprocessor involvement with the PWM modules can be a significant burden on the microprocessor's ability to keep up with the other (non-PWM-related) tasks.

There have been efforts to support the microprocessor so that it can better keep up with non-PWM-related tasks. One approach is to design into the chip additional logic circuitry dedicated to performing some of these PWM-related tasks, thereby offsetting some of this burden directly. In such applications, the counter's outputs are sometimes used by the microprocessor software to calculate the desired parameters of the input pulse represented by the PWM output signal. With the ever-increasing clocking speeds of the microprocessors, another approach is simply to employ the increased clocking speed so that the other tasks are completed more quickly, thereby making available more time for the microprocessors to support the burdensome PWM-related tasks. Unfortunately, for many chips and applications, chip real estate and available processing time are not highly-negotiable commodities.

Other applications typically require faster data-processing speeds and more versatile functionality (or programmable flexibility) within the chip, wherein fewer chip pins are available for dedicated functions. Typically, for those compact chip designs having fewer chip pins available for dedicated functions, there is little remaining real estate, if any, for dedicated circuitry. In these instances, it is advantageous to provide multiple functions for each chip pin, with the functionality being defined in that latter stages of manufacturing or, programmably, in the field.

### SUMMARY

The present invention is directed to a pulse-width modulation (PWM) circuit that addresses the above-mentioned challenges and, although not required, to a PWM technique that can be implemented without circuitry such as a compare-value-holding register and a comparator that are dedicated to the PWM function. The present invention is exemplified in a number of implementations and applications, some of which are summarized below.

According to one example embodiment, the present invention is directed to techniques and circuit arrangements in which a PWM signal is generated in response to a counter load value and a clock signal. The technique involves use of a counter arrangement having an input register for storing the counter load value. A first logic circuit responds to the stored load value and to a control signal for providing a logic circuit output that is either the load value or a complement of the load value. Further, the PWM circuit has a counter circuit that counts relative to the logic circuit output and reinitiates counting relative to the logic circuit output in response to the control signal. A second logic circuit produces the control signal in response to the counter reaching an overflow threshold value and the PWM output signal can be provided from or in connection with the control signal. These example implementations make possible a PWM function to be added to an existing timer/counter with a relatively small amount of additional circuitry, addressing issues including those discussed in the Background hereinabove.

Other aspects are directed to additional uses of the above-mentioned control signal. For example, in one more specific embodiment, the control signal is used to provide timing to the first logic circuit in connection with provision of the logic circuit output as either the load value or a complement of the load value. In another specific embodiment, the control signal is used to indicate whether a correction should be made to account for a one's-complement implementation used in connection with providing the logic circuit output that as a complement of the load value.

Advantageously, the above technique (and variations thereof) can be implemented without displacing the functionality provided by counters presently existing in many commercially-available chips. By providing only a few additional logic gates, current counter designs can be adapted to selectively (or programmably) provide either their existing functionality or PWM functionality. For those chip designs having concerns regarding circuit space and/or available chip pins, implementations of the present invention can be extremely beneficial. The above summary of the present invention is not intended to describe each illustrated embodiment or every implementation of the present invention. The figures and detailed description that follow more particularly exemplify these embodiments.

### BRIEF DESCRIPTION OF THE DRAWINGS

The invention may be more completely understood in consideration of the detailed description of various embodiments of the invention which follows in connection with the accompanying drawings, in which:

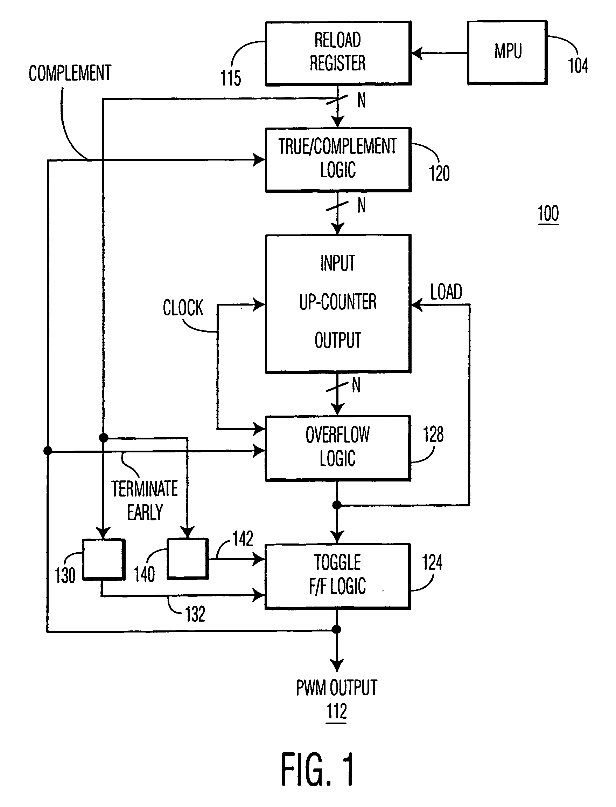

FIG. 1 is a block diagram illustrating various example circuits that can be used to implement and carry out various aspects of the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the spirit and scope of the invention as defined by the appended claims.

### DETAILED DESCRIPTION OF THE DISCLOSED EMBODIMENTS

The present invention is believed to be applicable to a variety of different types of applications requiring or benefiting from pulse-width modulation (PWM) functionality, and has been found to be particularly useful for chip applications benefiting from a PWM-circuit architecture that can be readily reconfigured to provide alternative counter-related functions or that are circuit-space challenged and cannot accommodate conventional PWM circuitry such as a compare-value-holding register and comparator circuitry. Although the not necessarily limited to such applications, various aspects of the invention may be appreciated through a discussion of various examples using this context.

According to one example embodiment, the present invention provides a reconfigurable PWM-circuit architecture having selectable operation modes. The architecture includes a pulse-width modulation circuit for generating a PWM output signal, with the PWM output signal largely being generated using a controlled feedback for an auto-reloading counter. Many conventional auto-reloading counters have an output toggle function which indicates the occurrence of an overflow condition for the counter. One particular implementation uses the output toggle function (or "toggle signal") to provide feedback to the auto-reloading timer/counter ("counter") to change the timer count. Specifically, the timer count is complemented in the reload path between an input-holding register (*e.g.,* used to load the counting machine) and the counting register (*e.g.,* used by the counting machine to perform the sequential counting). When the counter overflows, the contents of the input-holding register is transferred to the counting register and counting proceeds from the value in the counting register.

In accordance with the present invention, with its period being constant, the PWM signal can be viewed as being composed of the sum of the high and low marks along a binary timeline. For example, if the total period is 256 timer counts, then the high and low times along the timeline defining the total period are the negative values of each other; high =
- low, low = -high. In this context, a PWM signal is achieved by loading a binary number, "X", into the counting register on one phase of the toggle signal and loading the binary number, "-X", on the other phase. In this manner, for the one phase the counting machine counts from binary number, "X", until the overflow condition occurs, at which time the other phase of the toggle signal loads for counting the binary number, "-X", thereby causing the counter to count until the one phase causes the counting machine to again count from the binary number, "X".

Consider the specific example where the counting machine and each of its associated registers is "N" bits wide, where N equals 3. This example permits 2^{N} (or eight) binary counting states for representing the PWM signal. Assuming that the counter counts up (versus down) and that the input-holding register is initially loaded with the binary number "101" to indicate that the PWM cycle should produce a duty cycle ratio of 5-high/3-low, the counting machine receives "101" from the counting register and counting proceeds from this binary value in the counting register. During this counting, the toggle signal remains in the same state for the three cycles. Upon the count reaching the overflow condition, as indicated by a transition to the other phase of the toggle signal which loads the binary number, "-X" or in this instance "011". Loading "011" into the counting register causes the counting machine to count so that the toggle signal remains in the opposite state for the five cycles that correspond to reaching the overflow condition. When the counting machine again reaches the overflow condition, the feedback provided from the toggle signal causes "101" to be loaded once again into the counting register and counting proceeds as described above, thereby establishing the desired duty cycle of 5-high/3-low. Such an approach is approximation for certain situations in which the one's complement does not produce the desired duty cycle exactly. However, this can be acceptable for many applications in which achieving the exact duty cycle is not critical and/or where "N" being relatively large renders the inaccuracy relatively insignificant.

Other embodiments of the present invention overcome the approximation, and provide the desired duty cycle exactly, using logic that effectively or actually causes a "two's complement" (rather than a one's complement) of the binary value in the reload path between an input-holding register and the counting register. Thus, instead of simply inverting each of the bits of the binary number "X", the binary number "-X" is produced using logic that achieves a true "two's complement" and the desired duty cycle ratio is achieved by permitting the counting machine to count the full number of cycles from the true complemented binary value in the input-holding register.

The skilled artisan will recognize that the "complement" can be achieved in various ways including, for example, using 2-input XOR gates (or "XNOR" gates, either one proving an XOR function) for each of the N bits between the input-holding register and the counting register. For example, in an 80C51-type microcontroller chip, a 2-input XOR gate is added between the THx and TLx registers for each of the eight bits. One input to the XOR is the output of the THx register and the other input is the toggled pin, Tx. The outputs of the XOR gates are fed into the TLx register. Thus, the TLx register is loaded with either the programmed value "X" or the complement of "X" depending on the state of the toggled output, Tx.

There are also various ways for achieving a true "two's complement" in the above context. One way is to use more sophisticated logic circuitry along with or in place of the circuitry providing the XOR function, as is conventional in other applications employing "two's complement" computations. Alternatively, the "two's complement" can be achieved by using the above-discussed XOR-function logic for each of the N bits between the input-holding register and the counting register, and also using logic to trigger the toggle function one cycle/count in advance of the counter overflow condition. This can be achieved, for example, by locating an OR gate (or a NOR gate, each providing an OR function) in the path of the least significant bit (LSB) of the parallel output of the counter so that the output of the OR gate drives the LSB of the logic (or AND gate) used to detect the counter overflow condition (typically when each of the N bits is a logical "1"). The OR gate is used only when the toggle signal (typically latched) has been produced for the opposite (or "-X" phase). Thus, one of the two inputs to the single OR gate is the LSB of the parallel output of the counter, the other input is the latched toggle signal, and the output of the OR gate drives the LSB input of the AND gate used to detect the counter overflow condition. In this manner, the single OR gate is used to detect the counter reaching an overflow threshold value. In view of the multiple examples, it will be appreciated that when this two's complement logic is not being used, the overflow threshold value is the same as the counter's overflow condition.

Anticipating the counter's overflow condition in this manner is advantageous for at least two reasons. First, this approach requires very little additional logic, e.g., the OR gate being the significant addition to the EXOR logic. Second, the approach provides an extremely accurate two's complement, even for those applications where N is small.

FIG. 1 illustrates various example circuits that can be used to provide architecture for the above-discussed aspects of the present invention. In FIG. 1, a pulse-width modulation circuit 100 includes a tool, such as microprocessor (or microcontroller denoted "MPU") 104, for initially loading for the input (reload) register 110 and defining the duty cycle for the pulse-width modulated output signal at port 112. The input register 110 is designed to store and output the loaded value in parallel for the counter 116 in either unmodified form or complemented form. In the example shown in FIG. I, the loaded value is presented through a complement logic circuit 120 that produces a one's complement of the load value only when a toggle flip/flop logic 124 indicates that the "-X" condition/phase is present. As previously discussed, this one's complement function can be achieved via EXOR gates. During the "X" condition/phase, the complement logic circuit 120 simply passes the load value through to the counter 116.

The counter 116 is an up-counter adapted to count relative to, *e.g.,* beginning from, the loaded value (*i.e.,* the logic circuit output) at a rate defined by the clock signal, and to reinitiate counting relative to the logic circuit output in response to the counter's overflow logic 128 directing this reload upon the counter reaching a threshold count.

Using the OR gate function discussed above, the counter's overflow logic 128 can be implemented to provide the correction discussed above in connection with achieving a true "two's complement" for the "-X" condition/phase. In this manner, the counter's overflow logic 128 directs the counter 116 to reload when an actual overflow condition being present during the "X" condition/phase and also when an actual overflow condition is anticipated during the "-X" condition/phase.

Also according to the present invention, variations of the above technique can be performed in a microprocessor using software to implement each of the loading, complementing, and counting functions. In one such specific implementation, a timer flag interrupt is used in response to an overflow condition occurring and, in response, the state of the output pin is checked to determine which of the two possible values (unmodified or complemented) needs to be loaded for the next counting cycle.

In a more particular example implementation of the present invention, one or more logic circuits are added that force the appropriate output state when the count is either 0000 0000 or 1111 1111, and effectively force the PWM output high for a count of zero and low for a count of maximum. This can be implemented with simple gates to drive either preset or clear inputs to the circuit (*e.g.*, to a toggle flip-flop) or directly drive a port pin logic to effect the appropriate output. This is particularly useful for addressing difficulties associated with minimum and maximum possible counts (*e.g.*, 0000 0000 and 1111 1111 for an 8-bit counter), which have been commonly addressed by forcing the PWM output high at a count of zero, and low at a count of maximum. In this regard, FIG. 1 shows one example implementation wherein a minimum (*e.g.,* all zero's) detector 130 is adapted to send a preset signal 132 to the toggle flip/flop logic 124 to force the PWM output high, and a maximum (*e.g.,* all one's) detector 140 is adapted to send a clear signal 142 to the toggle flip/flop logic 124 to force the PWM output low.

The various example embodiments described above are provided by way of illustration only and should not be construed to limit the invention. Based on the above discussion and illustrations, those skilled in the art will readily recognize that various modifications and changes may be made to the present invention without strictly following the exemplary embodiments and applications illustrated and described herein. Such modifications and changes do not necessarily depart from the scope of the present invention that is set forth in the following claims.

## Claims

1. A pulse-width modulation circuit (100) for generating a pulse-width modulated output signal (112) in response to a counter load value and a clock signal, comprising:
- a counter arrangement including an input register (110) adapted to store the counter load value and a first logic circuit (120) responsive to the stored load value and a control signal, the first logic circuit being adapted to provide a logic circuit output that is either the load value or a complement of the load value,
- the counter arrangement further including a counter circuit (116) adapted to count relative to the logic circuit output according to the clock signal, and to reinitiate counting relative to the logic circuit output in response to the control signal; and
- a second logic circuit (128) adapted to produce the control signal in response to the counter reaching an overflow threshold value.

2. The pulse-width modulation circuit of claim 1, wherein the overflow threshold value is an overflow condition for the counter.

3. The pulse-width modulation circuit of claim 1, wherein the overflow threshold value corresponds to one count different from an overflow condition for the counter.

4. The pulse-width modulation circuit of claim 1, wherein the first logic circuit (120) includes an EXOR function responsive to the stored load value and the control signal on a bit-wise basis.

5. The pulse-width modulation circuit of claim 1, wherein the first logic circuit (120) includes an EXOR function responsive to the stored load value and the control signal on a bit-wise basis, and the complement of the load value is a one's complement value.

6. The pulse-width modulation circuit of claim 1, wherein the complement of the load value is a one's complement value.

7. The pulse-width modulation circuit of claim 1, wherein the complement of the load value is a two's complement value.

8. The pulse-width modulation circuit of claim 1, wherein the second logic circuit (128) is further adapted to anticipate the counter reaching an overflow condition.

9. The pulse-width modulation circuit of claim 1, wherein the overflow threshold value is an overflow condition for the counter.

10. The pulse-width modulation circuit of claim 1, wherein the control signal is produced in response to the second logic circuit (128) anticipating the counter reaching an overflow threshold value when counting from the logic circuit output being a selected one of either the load value or its complement.

11. The pulse-width modulation circuit of claim 1, further including a microprocessor circuit (104) adapted to define a duty cycle of the pulse-width modulated output signal as a function of the counter load value.

12. The pulse-width modulation circuit of claim 1, wherein the pulse-width modulated output signal has a duty cycle corresponding to a function of the control signal, and further including a microprocessor circuit adapted to change the duty cycle by controlling the counter load value.

13. The pulse-width modulation circuit of claim 1, further comprising a logic circuit (130, 140) adapted to force an appropriate output state at minimum and maximum counts that correspond to a counter, the logic circuit being adapted to force the PWM output high at a count of minimum, and low at a count of maximum.

14. The pulse-width modulation circuit of claim 13, wherein the logic circuit includes at least one gate adapted to drive selected inputs to a toggle flip-flop (124) in the circuit to force the PWM output.

15. The pulse-width modulation circuit of claim 13, wherein the logic circuit is adapted to directly drive a port pin logic to force the PWM output.

16. For use in a digital circuit having a clock signal, a method for generating a pulse-width modulated signal in response to a counter load value, the method comprising:
- storing the counter load value (110);
- responsive to the stored load value and a control signal, producing a logic circuit output (120) that is either the load value or a complement of the load value;
- in response to the logic circuit output and using a digital counter (116), counting relative to the logic circuit output according to the clock signal and reinitiating the counting relative to the logic circuit output in response to the control signal; and
- producing the control signal in response to the counting reaching an overflow threshold value (128).

17. The method of claim 16, wherein the overflow threshold value is an overflow condition for the counter.

18. The method of claim 16, wherein the overflow threshold value corresponds to one count different from an overflow condition for the counter.

19. The method of claim 16, wherein producing a logic circuit output that is a complement of the load value includes performing an EXOR function responsive to the stored load value and the control signal on a bit-wise basis.

20. The method of claim 16, wherein producing a logic circuit output that is a complement of the load value includes performing an EXOR function responsive to the stored load value and the control signal on a bit-wise basis, the complement of the load value being a one's complement value.

21. The method of claim 16, wherein the complement of the load value is a one's complement value.

22. The method of claim 16, wherein the complement of the load value is a two's complement value.

23. The method of claim 16, wherein the overflow threshold value is an overflow condition for the counter.

24. The method of claim 16, wherein the overflow threshold value anticipates an overflow condition for the counter.

25. The method of claim 16, wherein the control signal is produced in response to the second logic circuit (128) anticipating the counter (116) reaching the overflow threshold value when counting from the logic circuit output being a selected one of either the load value or its complement.

26. The method of claim 16, further including defining a duty cycle of the pulse-width modulated output signal as a function of the counter load value.

27. The method of claim 16, wherein the pulse-width modulated output signal has a duty cycle corresponding to a function of the control signal, and further including changing the duty cycle by controlling the counter load value.

## Patentansprüche

1. Impulsbreitenmodulationsschaltung (100) zum Generieren eines impulsbreitenmodulierten Ausgangssignals (112) in Reaktion auf einen Zählerladewert und ein Taktsignal, umfassend:
- eine Zähleranordnung, einschließend ein Eingaberegister (110), dazu geeignet, den Zählerladewert zu speichern, und eine auf den gespeicherten Ladewert und ein Steuersignal reagierende erste logische Schaltung (120), wobei die erste logische Schaltung dazu geeignet ist, einen Ausgangswert der logischen Schaltung bereitzustellen, der entweder der Ladewert oder ein Komplement des Ladewerts ist,
- die Zähleranordnung, weiterhin einschließend eine Zählerschaltung (116), dazu geeignet, relativ zu dem Ausgangswert der logischen Schaltung gemäß dem Taktsignal zu zählen und den Zählvorgang relativ zu dem Ausgangswert der logischen Schaltung in Reaktion auf das Steuersignal zu reinitialisieren und
- eine zweite logische Schaltung (128), dazu geeignet, das Steuersignal in Reaktion auf das Erreichen eines Überlaufschwellenwerts durch den Zähler zu erzeugen.

2. Die Impulsbreitenmodulationsschaltung nach Anspruch 1, wobei der Überlaufschwellenwert eine Überlaufbedingung für den Zähler ist.

3. Die Impulsbreitenmodulationsschaltung nach Anspruch 1, wobei der Überlaufschwellenwert einem Wert entspricht, der sich um einen Zählwert von einer Überlaufbedingung für den Zähler unterscheidet.

4. Die Impulsbreitenmodulationsschaltung nach Anspruch 1, wobei die erste logische Schaltung (120) eine auf den gespeicherten Ladewert und das Steuersignal auf einer bitweisen Basis reagierende EXOR-Funktion einschließt.

5. Die Impulsbreitenmodulationsschaltung nach Anspruch 1, wobei die erste logische Schaltung (120) eine auf den gespeicherten Ladewert und das Steuersignal auf einer bitweisen Basis reagierende EXOR-Funktion einschließt und das Komplement des Ladewerts ein Einerkomplementwert ist.

6. Die Impulsbreitenmodulationsschaltung nach Anspruch 1, wobei das Komplement des Ladewerts ein Einerkomplementwert ist.

7. Die Impulsbreitenmodulationsschaltung nach Anspruch 1, wobei das Komplement des Ladewerts ein Zweierkomplementwert ist.

8. Die Impulsbreitenmodulationsschaltung nach Anspruch 1, wobei die zweite logische Schaltung (128) weiterhin dazu geeignet ist, das Erreichen einer Überlaufbedingung durch den Zähler zu antizipieren.

9. Die Impulsbreitenmodulationsschaltung nach Anspruch 1, wobei der Überlaufschwellenwert eine Überlaufbedingung für den Zähler ist.

10. Die Impulsbreitenmodulationsschaltung nach Anspruch 1, wobei das Steuersignal erzeugt wird in Reaktion auf die zweite logische Schaltung (128) in Antizipation des Erreichens eines Überlaufschwellenwerts durch den Zähler bei Zählen ab dem Ausgangswert der logischen Schaltung, der entweder der Ladewert oder dessen Komplement ist.

11. Die Impulsbreitenmodulationsschaltung nach Anspruch 1, weiterhin einschließend eine Mikroprozessorschaltung (104), dazu geeignet, ein Tastverhältnis des impulsbreitenmodulierten Ausgangssignals als eine Funktion des Zählerladewerts zu definieren.

12. Die Impulsbreitenmodulationsschaltung nach Anspruch 1, wobei das impulsbreitenmodulierte Ausgangssignal ein Tastverhältnis aufweist, das einer Funktion des Steuersignals entspricht, und weiterhin einschließend eine Mikroprozessorschaltung, dazu geeignet, das Tastverhältnis durch Steuern des Zählerladewerts zu ändern.

13. Die Impulsbreitenmodulationsschaltung nach Anspruch 1, weiterhin umfassend eine logische Schaltung (130, 140), dazu geeignet, einen entsprechenden Ausgangszustand bei einem Zähler entsprechenden Minimal- und Maximalzählwerten zu erzwingen, wobei die logische Schaltung dazu geeignet ist, den PWM-Ausgang bei einem Minimalzählwert auf High und bei einem Maximalzählwert auf Low zu zwingen.

14. Die Impulsbreitenmodulationsschaltung nach Anspruch 13, wobei die logische Schaltung zumindest ein Gatter einschließt, dazu geeignet, ausgewählte Eingänge eines T-Flipflops (124) in der Schaltung anzusteuern, um den PWM-Ausgang zu erzwingen.

15. Die Impulsbreitenmodulationsschaltung nach Anspruch 13, wobei die logische Schaltung dazu geeignet ist, eine Portpin-Logik direkt anzusteuern, um den PWM-Ausgang zu erzwingen.

16. Zur Anwendung in einer ein Taktsignal aufweisenden digitalen Schaltung ein Verfahren zum Generieren eines impulsbreitenmodulierten Signals in Reaktion auf einen Zählerladewert, das Verfahren umfassend:
- Speichern des Zählerladewerts (110),
- reagierend auf den gespeicherten Ladewert und ein Steuersignal Erzeugen einer Ausgangswerts einer logischen Schaltung (120), der entweder der Ladewert oder ein Komplement des Ladewerts ist,
- in Reaktion auf den Ausgangswert der logischen Schaltung und unter Verwendung eines digitalen Zählers (116) Zählen relativ zu dem Ausgangswert der logischen Schaltung gemäß dem Taktsignal und Reinitialisieren des Zählvorgangs relativ zu dem Ausgangswert der logischen Schaltung in Reaktion auf das Steuersignal und
- Erzeugen des Steuersignals in Reaktion auf das Erreichen eines Überlaufschwellenwerts (128) während des Zählvorgangs.

17. Das Verfahren nach Anspruch 16, wobei der Überlaufschwellenwert eine Überlaufbedingung für den Zähler ist.

18. Das Verfahren nach Anspruch 16, wobei der Überlaufschwellenwert einem Wert entspricht, der sich um einen Zählwert von einer Überlaufbedingung für den Zähler unterscheidet.

19. Das Verfahren nach Anspruch 16, wobei das Erzeugen eines Ausgangswerts der logischen Schaltung, der ein Komplement des Ladewerts ist, das Ausführen einer auf den gespeicherten Ladewert und das Steuersignal auf einer bitweisen Basis reagierenden EXOR-Funktion einschließt.

20. Das Verfahren nach Anspruch 16, wobei das Erzeugen eines Ausgangswerts der logischen Schaltung, der ein Komplement des Ladewerts ist, das Ausführen einer auf den gespeicherten Ladewert und das Steuersignal auf einer bitweisen Basis reagierenden EXOR-Funktion einschließt, wobei das Komplement des Ladewerts ein Einerkomplementwert ist.

21. Das Verfahren nach Anspruch 16, wobei das Komplement des Ladewerts ein Einerkomplementwert ist.

22. Das Verfahren nach Anspruch 16, wobei das Komplement des Ladewerts ein Zweierkomplementwert ist.

23. Das Verfahren nach Anspruch 16, wobei der Überlaufschwellenwert eine Überlaufbedingung für den Zähler ist.

24. Das Verfahren nach Anspruch 16, wobei der Überlaufschwellenwert eine Überlaufbedingung für den Zähler antizipiert.

25. Das Verfahren nach Anspruch 16, wobei das Steuersignal erzeugt wird in Reaktion auf die zweite logische Schaltung (128) in Antizipation des Erreichens eines Überlaufschwellenwerts durch den Zähler bei Zählen ab dem Ausgangswert der logischen Schaltung, der entweder der Ladewert oder dessen Komplement ist.

26. Das Verfahren nach Anspruch 16, weiterhin einschließend das Definieren eines Tastverhältnisses des impulsbreitenmodulierten Ausgangssignals als eine Funktion des Zählerladewerts.

27. Das Verfahren nach Anspruch 16, wobei das impulsbreitenmodulierte Ausgangssignal ein Tastverhältnis aufweist, das einer Funktion des Steuersignals entspricht, und weiterhin einschließend das Ändern des Tastverhältnisses durch Steuern des Zählerladewerts.

## Revendications

1. Circuit de modulation de largeur d'impulsion (100) pour générer un signal de sortie modulé en largeur d'impulsion (112) en réponse à une valeur de charge de compteur et à un signal d'horloge, comprenant :
un agencement de compteur comprenant un registre d'entrée (110) adapté pour mémoriser la valeur de charge de compteur et un premier circuit logique (120) répondant à la valeur de charge mémorisée et un signal de commande, le premier circuit logique étant adapté pour fournir une sortie de circuit logique qui est soit la valeur de charge soit un complément de la valeur de charge,
l'agencement de compteur comprenant en outre un circuit compteur (116) adapté pour compter par rapport à la sortie de circuit logique selon le signal d'horloge et
pour re-initier le compteur par rapport à la sortie de circuit logique en réponse au signal de commande ; et
un second circuit logique (128) adapté pour produire le signal de commande en réponse au compteur atteignant une valeur de seuil de dépassement.

2. Circuit de modulation de largeur d'impulsion selon la revendication 1, dans lequel la valeur de seuil de dépassement est une condition de dépassement pour le compteur.

3. Circuit de modulation de largeur d'impulsion selon la revendication 1, dans lequel la valeur de seuil de dépassement correspond à une condition de dépassement pour le compteur, à un coup d'écart.

4. Circuit de modulation de largeur d'impulsion selon la revendication 1, dans lequel le premier circuit logique (120) comprend une fonction EXOR répondant à la valeur de charge mémorisée et au signal de commande sur une base binaire.

5. Circuit de modulation de largeur d'impulsion selon la revendication 1, dans lequel le premier circuit logique (120) comprend une fonction EXOR répondant à la valeur de charge mémorisée et au signal de commande sur une base binaire, et le complément de la valeur de charge est une valeur de complément à un.

6. Circuit de modulation de largeur d'impulsion selon la revendication 1, dans lequel le complément de la valeur de charge est une valeur de complément à un.

7. Circuit de modulation de largeur d'impulsion selon la revendication 1, dans lequel le complément de la valeur de charge est une valeur de complément à deux.

8. Circuit de modulation de largeur d'impulsion selon la revendication 1, dans lequel le second circuit logique (128) est en outre adapté pour anticiper le compteur atteignant une condition de dépassement.

9. Circuit de modulation de largeur d'impulsion selon la revendication 1, dans lequel la valeur de seuil de dépassement est une condition de dépassement pour le compteur.

10. Circuit de modulation de largeur d'impulsion selon la revendication 1, dans lequel le signal de commande est produit en réponse au second circuit logique (128) anticipant le compteur atteignant une valeur de seuil de dépassement en comptant à partir de la sortie de circuit logique qui est sélectionnée parmi la valeur de charge et son complément.

11. Circuit de modulation de largeur d'impulsion selon la revendication 1, comprenant en outre un circuit microprocesseur (104) adapté pour définir un cycle de travail du signal de sortie modulé en largeur d'impulsion comme fonction de la valeur de charge de compteur.

12. Circuit de modulation de largeur d'impulsion selon la revendication 1, dans lequel le signal de sortie modulé en largeur d'impulsion a un cycle de travail correspondant à une fonction du signal de commande, et comprend en outre un circuit microprocesseur adapté pour changer le cycle de travail en commandant la valeur de charge de compteur.

13. Circuit de modulation de largeur d'impulsion selon la revendication 1, comprenant en outre un circuit logique (130, 140) adapté pour contraindre un état de sortie approprié à des comptes minimum et maximum qui correspondent à un compteur, le circuit logique étant adapté pour contraindre la sortie PWM à un niveau élevé à un compte minimum, et à un niveau faible à un compte maximum.

14. Circuit de modulation de largeur d'impulsion selon la revendication 13, dans lequel le circuit logique comprend au moins une passerelle adaptée pour entraîner des entrées sélectionnées à un interrupteur à bascule bistable (124) dans le circuit pour contraindre la sortie PWM.

15. Circuit de modulation de largeur d'impulsion selon la revendication 1, dans lequel le circuit logique est adapté pour entraîner directement une logique de fiche de port pour contraindre la sortie PWM.

16. Procédé pour générer un signal modulé en largeur d'impulsion en réponse à une valeur de charge de compteur, destiné à être utilisé dans un circuit numérique ayant un signal d'horloge, le procédé comprenant les étapes consistant à :
- mémoriser la valeur de charge de compteur (110) ;
- produire, en réponse à la valeur de charge mémoriser et à un signal de commande, une sortie de circuit logique (120) qui est soit la valeur de charge soit un complément de la valeur de charge ;
- compter, en réponse à la sortie de circuit logique et à l'utilisation d'un compteur numérique (116), par rapport à la sortie de circuit logique selon le signal d'horloge et re-initier le comptage par rapport à la sortie de circuit logique en réponse au signal de commande ; et
- produire le signal de commande en réponse au compteur atteignant une valeur de seuil de dépassement (128).

17. Procédé selon la revendication 16, dans lequel la valeur de seuil de dépassement est une condition de dépassement pour le compteur.

18. Procédé selon la revendication 16, dans lequel la valeur de seuil de dépassement correspond à une condition de dépassement pour le compteur, à un coup d'écart.

19. Procédé selon la revendication 16, dans lequel la production d'une sortie de circuit logique qui est un complément de la valeur de charge comprend l'exécution d'une fonction EXOR en réponse à la valeur de charge mémorisée et au signal de commande sur une base binaire.

20. Procédé selon la revendication 16, dans lequel la production d'une sortie de circuit logique qui est un complément de la valeur de charge comprend l'exécution d'une fonction EXOR en réponse à la valeur de charge mémorisée et au signal de commande sur une base binaire, le complément de la valeur de charge étant une valeur de complément à un.

21. Procédé selon la revendication 16, dans lequel le complément de la valeur de charge est une valeur de complément à un.

22. Procédé selon la revendication 16, dans lequel le complément de la valeur de charge est une valeur de complément à deux.

23. Procédé selon la revendication 16, dans lequel la valeur de seuil de dépassement est une condition de dépassement pour le compteur.

24. Procédé selon la revendication 16, dans lequel la valeur de seuil de dépassement anticipe une condition de dépassement pour le compteur.

25. Procédé selon la revendication 16, dans lequel le signal de commande est produit en réponse au second circuit logique (128) anticipant le compteur (116) atteignant la valeur de seuil de dépassement en comptant à partir de la sortie de circuit logique qui est sélectionnée parmi la valeur de charge ou son complément.

26. Procédé selon la revendication 16, comprenant en outre la définition d'un cycle de travail du signal de sortie modulé en largeur d'impulsion comme fonction de la valeur de charge de compteur.

27. Procédé selon la revendication 16, dans lequel le signal de sortie modulé en largeur d'impulsion a un cycle de travail correspondant à une fonction du signal de commande, et comprend en outre le changement du cycle de travail en commandant la valeur de charge de compteur.
